# FASCICULE DE BREVET EUROPEEN

(11) **EP 2 936 682 B1**
(45) Date de publication et mention de la délivrance du brevet: **20.01.2021**
(21) Numéro de dépôt: 13827008.7
(22) Date de dépôt: 20.12.2013
(51) Int. Cl.: H03K 17/94, H01P 1/15

(54) **DISPOSITIF DE COMMUTATION DE SIGNAUX HYPERFREQUENCES NOTAMMENT DE DIMENSIONS NANOMETRIQUES, ET COMPOSANT ELECTRONIQUE INCORPORANT UN TEL DISPOSITIF**
MIKROWELLENSIGNALSCHALTVORRICHTUNG, INSBESONDERE IN NANOMETERGRÖSSE, UND ELEKTRONISCHES BAUTEIL MIT SOLCH EINER VORRICHTUNG
MICROWAVE SIGNAL SWITCHING DEVICE, PARTICULARLY OF NANOMETRIC SIZE, AND ELECTRONIC COMPONENT INCORPORATING SUCH A DEVICE

(30) Priorité: 21.12.2012 FR 1203563
(43) Date de publication de la demande: 28.10.2015
(73) Titulaire: Thales, 92400 Courbevoie (FR); Universite Des Sciences Et Technologies De Lille, 59655 Villeneuve D'Ascq Cedex (FR); Université Paris 6 Pierre et Marie Curie UPMC, 75005 Paris (FR)
(72) Inventeur: TRIPON-CANSELIET, Charlotte, 75252 Paris Cedex 05 (FR); CHAZELAS, Jean, 78851 Elancourt Cedex (FR); DECOSTER, Didier, 59100 Roubaix (FR)
(74) Mandataire: Marks & Clerk France
(86) Numéro de dépôt international: PCT/EP2013/077859
(87) Numéro de publication internationale: WO 2014/096431

(56) Documents cités:
- EP-A2- 1 860 663
- FR-A1- 2 908 569
- JP-A- H09 198 978
- US-A1- 2002 113 759
- HARRIS J S ET AL: "Photonic A/D conversion using low-temperature-grown gaas msm switches integrated with Si-CMOS", JOURNAL OF LIGHTWAVE TECHNOLOGY, IEEE SERVICE CENTER, NEW YORK, NY, US, vol. 21, no. 12, 1 décembre 2003 (2003-12-01), pages 3104-3115, XP011106380, ISSN: 0733-8724, DOI: 10.1109/JLT.2003.820054

## Description

La présente invention concerne un dispositif de commutation de signaux hyperfréquence, notamment de dimensions nanométriques. L'invention concerne également un composant électronique incorporant un tel dispositif. Elle s'applique notamment dans le domaine de la conversion analogique/numérique pour des applications touchant le domaine des télécommunications ou le domaine des systèmes de détection électromagnétiques. Ainsi, elle s'applique par exemple pour des récepteurs hyperfréquences fonctionnant à des fréquences correspondant aux ondes millimétriques ou à des récepteurs de bande instantanée de plusieurs gigahertz.

Avec les nouvelles applications de ces domaines, les besoins en bande passante augmentent régulièrement tout en s'accompagnant d'une demande de réduction de coûts, et donc de simplification de la chaîne de réception des signaux RF.

Plusieurs effets combinés mettent en relief le besoin de systèmes d'échantillonnage et de conversion de signaux analogiques en numérique.

Afin de traiter numériquement les signaux reçus, les chaînes de réception de ces récepteurs doivent disposer de fonctions de conversion analogique-numérique.

Ainsi, les télécommunications requièrent des bandes passantes de plus en plus élevées pour autoriser la transmission des flux denses de données dans les réseaux locaux sans fils (WLAN) notamment. On peut considérer qu'une loi équivalente à la loi de Moore apparaît pour les transmissions de données, à savoir que le débit de données des communications sans fil double tous les 18 mois, dépassant rapidement le taux de 1 Gbps.

En raison des limitations intrinsèques de la bande passante accessible par les convertisseurs analogique/numérique en cours de développement, les chaînes de réception hyperfréquences requièrent des fonctions de transposition complexes et coûteuses sans autres alternatives technologiques suggérées à ce jour.

En particulier, les technologies actuelles à base de semi-conducteurs ne permettent pas de disposer de codeurs analogiques-numérique fonctionnant au-delà de 2 à 3 GHz avec une dynamique élevée, souvent située au-delà de 50 dB de rapport signal sur bruit. Il est conventionnel d'introduire dans la chaîne de réception des fonctions de mélange hyperfréquence afin de transposer les signaux reçus dans la bande de fréquence compatible de l'entrée d'un codeur.

Lorsque les fréquences d'entrée sont très élevées, il faut recourir à plusieurs étages de mélange, ce qui accroît considérablement la complexité des chaînes de réception hyperfréquences.

Les dispositifs électroniques à commande optique peuvent être utilisés pour effectuer les fonctions de commutations ou d'échantillonnage nécessaires pour réaliser des convertisseurs notamment.

Dans le cadre d'une utilisation dans un système de réception analogique, un utilisateur cherche généralement un dispositif dont les performances de dynamique, de pertes d'insertion et de bruit soient optimisées et dont la puissance optique de commande soit la plus faible possible. En particulier, dans le cas d'un photo-interrupteur cela se traduit par un dispositif dont les deux états commandés optiquement, l'état passant et l'état bloqué, sont très différents en niveau de transmission, cette différence étant de plusieurs dizaines de décibels (dB). Un tel interrupteur, ou commutateur, peut être défini comme un dispositif comportant deux électrodes représentant un port d'entrée et un port de sortie déposés sur un substrat photoconducteur ainsi qu'une zone d'interaction constituée par la zone du substrat qui sépare les deux ports et qui sous l'action d'une onde lumineuse assure la continuité électrique entre les deux ports. L'acheminement de l'onde lumineuse de commande jusqu'à la zone du composant sur laquelle elle interagit (zone d'interaction) pour commander le fonctionnement du composant est généralement réalisé au moyen d'une fibre optique. L'optimisation de la puissance optique de commande s'obtient par la mise en œuvre de systèmes permettant de focaliser toute la lumière dans la zone d'interaction, avec des limitations qui sont de l'ordre de 10 µm pour une fibre monomode et de 50 µm pour une fibre multi-modes. La littérature fait état de nombreuses recherches sur la réalisation de photo-interrupteurs à éclairement par une puissance optique importante ayant un mode de fonctionnement ultra rapide, les temps en jeu étant de l'ordre de la picoseconde.

Cependant les dispositifs réalisés à ce jour présentent des caractéristiques et des performances qui limitent la fréquence d'utilisation aux fréquences compatibles du meilleur contraste entre l'état passant et l'état bloqué, noté ON/OFF. Ainsi, les dispositifs actuels sont limités à des fréquences de l'ordre de 1 à 2 GHz, leurs caractéristiques et performances étant les suivantes :
- Contraste ON/OFF faible, de l'ordre de 3 dB à 10 dB à la fréquence de 20 GHz ;
- Pertes d'insertion de l'ordre de 30 dB ;
- Puissance optique de commande élevée, de l'ordre de 100 mW moyen.

Pour un semi-conducteur donné, la réduction de la puissance optique de commande optique exige des dimensions beaucoup plus faibles au niveau de la zone éclairée, ces dimensions étant par exemple d'ordre nanométriques.

Un document FR 2 908 569 divulgue un dispositif de commutation d'un signal électrique dont la conduction est commandée par effet photoélectrique au moyen d'un faisceau lumineux.

Un but de l'invention est notamment de permettre la réalisation de dispositifs de commutation électronique à commande optique de très faibles dimensions, par exemple nanométrique, améliorant l'ensemble des performances cités ci-dessus, en termes de puissance, de pertes d'insertion et de contraste. A cet effet, l'invention a pour objet un dispositif de commutation d'un signal électrique commandé par une onde optique ayant un état passant et un état ouvert tel que défini dans la revendication 1, apte à être inséré dans une ligne de transmission hyperfréquence, ledit dispositif comportant un substrat semi-conducteur sur lequel sont réalisées deux pistes conductrices séparées par un gap assurant une isolation électrique entre les deux pistes reliées chacune à un port d'entrée et de sortie, à l'état passant le contact électrique entre les deux pistes étant établi en illuminant le substrat dans la zone du gap au moyen de l'onde optique, l'impédance d'entrée et l'impédance de sortie dudit dispositif de commutation étant désadaptées à l'impédance de la ligne de transmission à l'état ouvert et sont adaptées à l'impédance de la ligne de transmission à l'état passant.

A l'état ouvert l'impédance d'entrée et l'impédance de sortie sont par exemple supérieures à un kilo ohms.

La largeur des pistes conductrices décroit depuis les ports d'entrée et de sortie jusqu'au gap, la décroissance pouvant être linéaire. Avantageusement, les pistes ont par exemple une terminaison au niveau du gap de dimension équivalente à longueur du gap.

La structure du dispositif étant du type coplanaire, il comporte par exemple un plan de masse de chaque côté des pistes conductrices, la distance entre les plans de masse et les pistes restant sensiblement constante entre les ports d'entrée et de sortie et le gap.

La longueur du gap est par exemple inférieure à 1µm, elle peut être de l'ordre de 0,5 µm.

L'invention a également pour objet un composant électronique incorporant un dispositif selon l'invention tel que décrit précédemment. En particulier, un tel composant peut être un échantillonneur bloqueur.

D'autres caractéristiques et avantages de l'invention apparaîtront à l'aide de la description qui suit faite en regard de dessins annexés qui représentent :
- la figure 1, une illustration schématique d'une chaîne de réception ;
- les figures 2a et 2b, un exemple de dispositif de commutation à commande optique selon l'art antérieur ;
- les figures 3a et 3b, un exemple de dispositif de commutation à commande optique selon l'invention ;
- la figure 4, un autre exemple de réalisation d'un dispositif selon l'invention dans une structure de type coplanaire avec resserrement des masses ;
- la figure 5, un exemple de réalisation d'un dispositif selon l'invention dans une structure de type microruban ;
- la figure 6, un schéma équivalent d'un exemple de réalisation d'un dispositif selon l'invention à l'état ouvert illustrant le calcul des dimensions dudit dispositif.

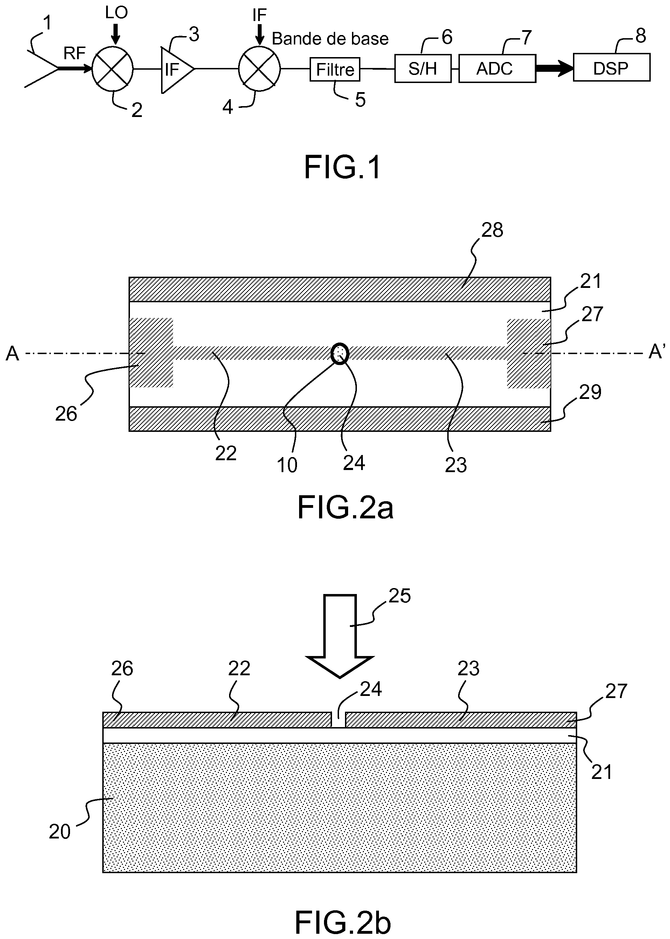

La figure 1 illustre, de façon schématique, une chaîne de réception classique, utilisé dans de nombreux systèmes actuels. En raison des limitations intrinsèque de la bande passante accessible par les convertisseurs analogique-numérique en cours de développement, les chaînes de réception hyperfréquence requièrent des fonctions de transposition complexes et coûteuses sans autre alternative. Ainsi, la chaîne de réception de la figure 1 comporte en sortie de l'antenne de réception 1 du signal hyperfréquence un premier mélangeur 2 ramenant la fréquence du signal dans une bande de fréquence intermédiaire. Un deuxième mélangeur 4 transpose le signal amplifié 3 en bande de base pour être échantillonné en haute fréquence par un échantillonneur-bloqueur 6 après filtrage 5 par exemple. Le signal échantillonné est converti numériquement par un convertisseur 7, le signal numérique étant pris en compte par des moyens de traitement 8.

Les systèmes futurs, encore plus que les systèmes actuels, nécessiteront de réaliser des récepteurs fonctionnant soit à très haute fréquence, à plusieurs dizaines de GHz, soit à très large bande passante instantanée, par exemple 20 GHz. De tels récepteurs nécessitent des fonctions de commutations très performantes. Des dispositifs de commutations à commande optique, capables de commuter très rapidement, peuvent répondre à ces fréquences de fonctionnement à conditions qu'ils présentent des performances suffisantes au niveau du contraste ON/OFF, supérieur à 50 dB par exemple. Il faut aussi qu'ils présentent des performances suffisantes en ce qui concerne la puissance optique nécessaire et les pertes d'insertions pour permettre un fonctionnement acceptable en termes de consommation d'énergie. De tels commutateurs constituent une fonction de commutation élémentaire pour des composants de la chaîne de réception, tels que les échantillonneurs-bloqueurs par exemple. Ils peuvent aussi être utilisés pour réaliser des mélangeurs, des déphaseurs et autres composants nécessitant une fonction de commutation élémentaire ultrarapide performante.

Les figures 2a et 2b présentent un exemple de réalisation d'un dispositif de commutation électronique à commande optique selon l'art antérieur, la figure 2a représentant une vue de dessus et la figure 2b une vue en coupe selon AA'. Le dispositif comporte un substrat semi-conducteur 22, 21 sur lequel sont placées deux pistes conductrices 22, 23. Le substrat semi-conducteur comporte par exemple au moins deux couches. Une première couche 20 est par exemple constituée d'arséniure de gallium (AsGa) semi-isolant servant de support. Afin d'obtenir des temps de réponse très courts, cette première couche est complétée en surface par une couche de semi-conducteur, épitaxiée à basse température (AsGa BT). Cette dernière couche peut par ailleurs être dopée.

Les pistes conductrices 22, 23 sont placées en alignement et séparées par un espace 24, appelé encore gap, ne portant pas de métallisation de façon à être isolées électriquement l'une de l'autre. Pour réaliser la fonction de commutation on apporte au substrat de l'énergie au moyen d'une onde lumineuse 25. Cet apport d'énergie a pour conséquence de rendre le substrat localement conducteur dans la zone éclairée 10 par injonction de porteurs dans cette zone, zone qui englobe le gap 24 séparant les deux pistes conductrices 22, 23. Cette zone 10 est encore appelée zone d'interaction. Une continuité électrique est ainsi établie entre ces deux pistes, correspondant à l'état passant du commutateur. Inversement si la zone d'interaction 10 cesse d'être éclairée, elle cesse par là même d'être conductrice et la continuité électrique est interrompue, le commutateur étant alors à l'état ouvert. Des dimensions typiques peuvent être les suivantes :
- Longueur du gap 24 = 10 µm
- Largeur d'une piste 22, 23 = 10 µm
- Diamètre de la zone éclairée, zone d'interaction 10 = 10 µm

La zone d'interaction 10 est donc sensiblement aux dimensions des pistes et du gap.

Le commutateur comporte par ailleurs deux ports d'entrée 26, 27, chaque port étant relié à une piste 22, 23. En pratique, les ports 26, 27 prolongent par exemple les pistes. Deux bandes conductrices 28,29 disposées de chaque côté des pistes conductrices 22, 23, et à égales distances, sont reliées à un potentiel de masse formant ainsi des plans de masse. Le commutateur tel qu'illustré par les figures 2a et 2b s'inscrit ainsi dans une ligne hyperfréquence du type coplanaire. Les dimensions entre les pistes centrales 22, 23 et plans de masse périphérique 28, 29 sont définies de telle sorte que le commutateur que l'impédance d'entrée ou de sortie du commutateur soit adaptée aux impédances caractéristiques des lignes hyperfréquence standards, c'est-à-dire 50 ohms ou 75 ohms comme dans tous les commutateurs classiques. La longueur du commutateur présenté en figure 2 est par exemple de l'ordre de 1 mm et sa largeur de l'ordre 100 µm. La qualité de la commutation est notamment caractérisée entre le contraste à l'état passant et le contraste à l'état ouvert, contraste ON/OFF défini précédemment. Un objectif de l'invention est de réaliser un dispositif de commutation dont les performances hyperfréquence sont optimisées dans le sens qu'elles maximisent ce contraste, correspondant à l'amélioration du rapport signal sur bruit et donc de la qualité de commutation. Par ailleurs, la puissance optique nécessaire à la commande doit être de préférence minimisée.

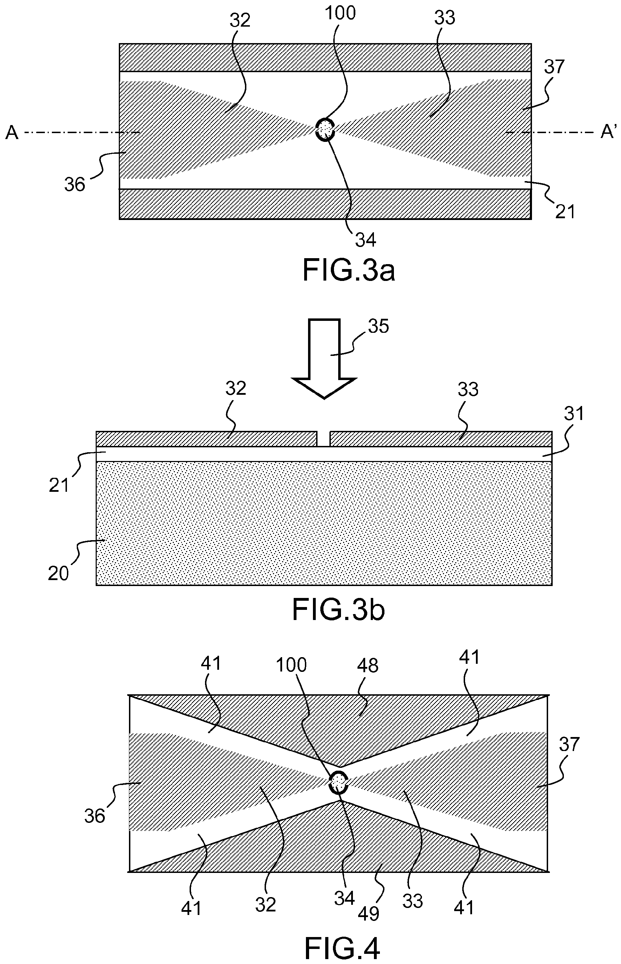

Les figures 3a et 3b illustrent un exemple de réalisation d'un dispositif de commutation selon l'invention. Comme pour les figures 2a et 2b, la figure 3a présente une vue de dessus et la figure 3b une vue en coupe selon AA'. Le dispositif comporte toujours un substrat semi-conducteur 20, 21, par exemple du type de celui des figures 2a et 2b, sur lequel sont placées des pistes conductrices 32, 33. La structure du commutateur est toujours du type coplanaire. Deux plans de masse 28, 29 sont donc placées de chaque côté des pistes conductrices 32,33.

Selon l'invention, ces pistes conductrices 32, 33 ont un profil particulier. Partant des ports d'entrée 36, 37, elles décroissent en largeur jusqu'à finir par exemple en pointe au niveau du gap 34 séparant ces deux pistes. Comme dans le cas précédent, un faisceau optique 35 éclaire une zone 100 englobant ce gap 34. Dans cet exemple de réalisation, les dimensions typiques peuvent être les suivantes :
- Longueur du gap 34 = 0,5 µm
- Diamètre de la zone éclairée, zone d'interaction 100 = 1 à 2 µm
- Largeur d'une piste conductrice 32, 33 au niveau du gap : elle est inférieure à 1 µm.

Ces grandeurs montrent dans cet exemple de réalisation, les pistes conductrices 32, 33 ont une terminaison de dimension équivalente à la longueur du gap, au niveau du gap. En d'autres termes, la largeur des pistes au niveau du gap est dans le même ordre de grandeur que la longueur du gap. La largeur des pistes est par exemple sensiblement égale à 0,5 µm. Pour obtenir une zone d'interaction 100 de si faible diamètre et donc confiner le faisceau dans une si faible surface, on dispose de moyen pour guider et focaliser le faisceau lumineux 35 vers cette zone 100.

Par ailleurs selon l'invention, les impédances d'entrée et de sortie du commutateur sont désadaptées lorsque celui-ci est à l'état ouvert. Ainsi le contraste entre l'état passant et l'état ouvert (ON/OFF) est augmenté. En effet, on augmente dans ce cas les pertes d'insertion à l'état ouvert (OFF). La désadaptation des impédances d'entrée et de sortie du commutateur génère des réflexions de signal à son entrée et à sa sortie, ce qui augmente les pertes en transmission. Ces pertes augmentent le contraste entre l'état passant et l'état bloqué en s'ajoutant à l'impédance hautement résistive de la zone d'interaction. Cette augmentation de contraste entre l'état passant et l'état ouvert exige cependant que les impédances d'entrée et de sortie du commutateur soient adaptées lorsque celui est à l'état passant.

La géométrie des pistes conductrices 32, 33 permet d'adapter les impédances d'entrée/sortie du commutateur aux impédances caractéristiques des lignes hyperfréquence auxquelles il est relié, 50 ohms ou 75 ohms pour les lignes standard, pour l'état passant et de désadapter ces impédances pour l'état ouvert.

Ainsi, un commutateur selon l'invention est tel que :
- l'impédance d'entrée/sortie du commutateur est désadaptée à l'impédance de la ligne de transmission interrompue en absence de commande optique correspondant à l'état ouvert ;
- l'impédance d'entrée/sortie du commutateur est adaptée à l'impédance de la ligne de transmission à l'état passant, plus particulièrement l'impédance de ligne est adaptée à la résistance créée par l'éclairement de la zone d'interaction 100.

Lors de l'éclairement, l'impédance de la zone d'interaction passe de quelques kilo-ohms, à l'état ouvert, à quelques dizaines d'ohms par confinement de la zone d'éclairement, à l'état passant. Cette impédance devient alors compatible avec l'impédance d'accès des pistes choisie pour la désadaptation à l'état ouvert (OFF), réduisant ainsi les réflexions de signaux le long du dispositif. Plus particulièrement, le gap est dimensionné en longueur et en largeur pour que l'impédance d'entrée et l'impédance de sortie du commutateur soit adaptée à l'impédance caractéristique de la ligne hyperfréquence, par exemple à une ligne hyperfréquence standard ayant une impédance caractéristique de 50 ohms ou 75 ohms. En pratique, il suffit que l'impédance d'entrée et l'impédance de sortie s'approchent de ces valeurs, c'est-à-dire soit de l'ordre de quelques dizaines d'ohms.

La figure 4 présente, par une vue de dessus un autre mode de réalisation possible d'un commutateur selon l'invention, toujours dans une structure du type coplanaire. Dans ce mode de réalisation, les plans de masse 48, 49 disposés de chaque côté des pistes 32, 33 se resserrent en direction de ces pistes de façon à laisser un espace 41 de largeur constante, ou presque, entre elles et les pistes.

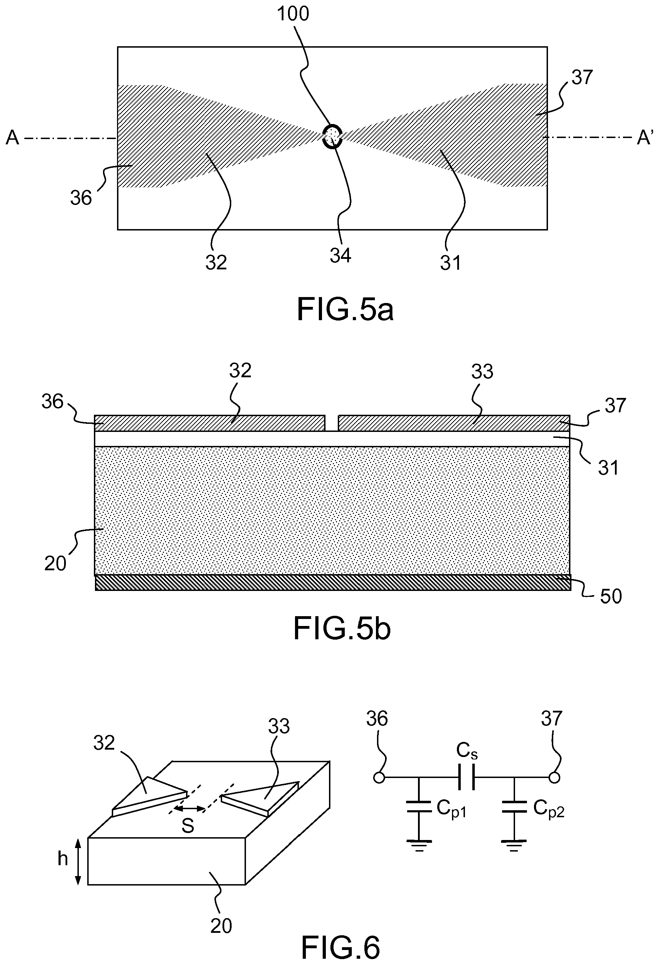

Les figures 5a et 5b présentent respectivement, par une vue de dessus et par une vue en coupe selon AA', un mode de réalisation possible d'un commutateur selon l'invention. Dans cet exemple de réalisation, la configuration est de type micro ruban, c'est-à-dire qu'il n'y a pas de plan de masse de chaque côté des pistes conductrices 32, 33 mais un plan de masse 50 situé en face arrière du substrat de GaAs semi-isolant.

La figure 6 illustre le schéma équivalent de l'interrupteur à l'état ouvert. Le schéma équivalent est composé de trois capacités Cs, Cp1, Cp2. Les capacités Cp1 et Cp2 représentent respectivement les capacités des pistes 22, 33 par rapport à un plan de masse. La capacité Cs, connectée entre les extrémités de Cp1 et Cp2, représente la capacité du gap de largeur s. Les valeurs de ces capacités dépendent des différentes dimensions en jeu. Elles dépendent notamment de l'épaisseur h du substrat semi-conducteur, de la largeur s du gap et de la géométrie des pistes 32, 33. La géométrie des pistes dépend notamment de la forme en pointe de ces dernières telle qu'illustrée par les figures 3a, 4 et 5, et notamment par la longueur de la pointe et sa largeur maximum.

L'impédance d'entrée et de sortie du commutateur à l'état ouvert sont elles-mêmes dépendante de ces capacités. On définit donc des dimensions permettant d'obtenir une désadaptation des impédances d'entrée et de sortie du commutateur.

Un autre paramètre de dimensionnement est la valeur de l'impédance d'entrée du commutateur à l'état passant. Celle-ci est adaptée à la ligne. Dans ce cas, la capacité Cs du schéma équivalent de la figure 6 est remplacée par une résistance que l'on peut calculer notamment en fonction de la largeur de gap s et de la largeur du flux de courant électrique créé lors de l'éclairement de la zone de gap. On peut ainsi définir des dimensions et une géométrie des pistes conductrices en fonction des contraintes imposées, notamment :
- largeur du gap inférieur à 1 µm par exemple ;
- adaptation de l'impédance d'entrée à l'état passant et ;
- désadaptation complète à l'état ouvert.

Les dimensions du substrat et la géométrie des pistes peuvent être aisément calculées par simulation.

Un dispositif selon l'invention tel que décrit précédemment peut avantageusement être incorporé dans des composants électroniques, fonctionnant en hyperfréquence notamment. Un exemple avantageux est celui d'un échantillonneur bloqueur devant fonctionner dans une large bande de fréquence instantanée. En incorporant un ou plusieurs dispositifs de commutation selon l'invention, il peut effectuer des échantillonnages à très hautes fréquences, tout en consommant peu d'énergie. En effet, un dispositif de commutation selon l'invention peut assurer un contraste ON/OFF supérieur à 30 dB à 20 GHz par exemple, avec une puissance optique de commande réduite à 10 mW moyen. D'autres composants électroniques nécessitant des fonctions de commutation ultra rapide peuvent avantageusement incorporer un dispositif de commutation selon l'invention.

## Revendications

1. Dispositif de commutation d'un signal électrique commandé par une onde optique (35) ayant un état passant et un état ouvert, apte à être inséré dans une ligne de transmission hyperfréquence, ledit dispositif comportant un substrat semi-conducteur (20, 21) sur lequel sont réalisées deux pistes conductrices (32, 33) séparées par un gap (34) assurant une isolation électrique entre les deux pistes reliées chacune à un port d'entrée et de sortie (36, 37), lesdites pistes conductrices (32,33) finissant au niveau dudit gap (34), la largeur des pistes conductrices (32, 33) décroissant depuis les ports d'entrée et de sortie (36, 37) jusqu'audit gap (34), à l'état passant le contact électrique entre les deux pistes étant établi en illuminant le substrat dans la zone (100) du gap au moyen de l'onde optique, **caractérisé en ce que** la géométrie desdites pistes conductrices (32, 33) est définie de façon à ce que l'impédance d'entrée et l'impédance de sortie dudit dispositif de commutation créées par l'éclairement de ladite zone (100) soient adaptées à l'impédance de ladite ligne de transmission, ladite impédance d'entrée et ladite impédance de sortie soient désadaptées à ladite ligne de transmission en absence d'éclairement de ladite zone (100).

2. Dispositif selon la revendication 1, **caractérisé en ce qu'**à l'état ouvert l'impédance d'entrée et l'impédance de sortie sont supérieures à un kilo ohms.

3. Dispositif selon l'une quelconque des revendications précédentes, **caractérisé en ce que** ladite largeur décroit de façon linéaire.

4. Dispositif selon l'une quelconque des revendications précédentes, **caractérisé en ce que** les pistes ont une terminaison au niveau du gap de dimension équivalente à longueur du gap.

5. Dispositif selon l'une quelconque des revendications précédentes, **caractérisé en ce que** sa structure étant du type coplanaire, il comporte un plan de masse (28, 48) de chaque côté des pistes conductrices (32,33), la distance entre les plans de masse et les pistes restant sensiblement constant entre les ports d'entrée et de sortie et le gap.

6. Dispositif selon l'une quelconque des revendications précédentes, **caractérisé en ce que** la longueur du gap est inférieure à 1µm

7. Dispositif selon la revendication 5, **caractérisé en ce que** la longueur du gap est de l'ordre de 0,5 µm.

8. Composant électronique, **caractérisé en ce qu'**il incorpore un dispositif selon l'une quelconque des revendications précédentes.

9. Composant électronique selon la revendication 8, **caractérisé en ce qu'**il réalise la fonction d'échantillonneur bloqueur (6).

## Patentansprüche

1. Schaltvorrichtung eines elektrischen Signals, gesteuert durch eine optische Welle (35), welche einen EIN-Zustand und einen AUS-Zustand besitzt, welches in der Lage ist, in eine Mikrowellenübertragungsleitung eingesetzt zu werden, wobei die Vorrichtung ein Halbleitersubstrat (20, 21) umfasst, an welchem zwei leitfähige Spuren (32, 33) gebildet sind, getrennt durch einen Spalt (34), welcher eine elektrische Isolation zwischen den beiden Spuren gewährleistet, welche jeweils mit einem Eingangs- und Ausgangsanschluss (36, 37) verbunden sind, wobei die leitfähigen Spuren (32,33) auf Höhe des Spaltes (34) enden, wobei die Breite der leitfähigen Spuren (32, 33) ab den Eingangs- und Ausgangsanschlüssen (36, 37) bis zu dem Spalt (34) abnimmt, wobei im EIN-Zustand der elektrische Kontakt zwischen den beiden Spuren hergestellt wird, indem das Substrat in dem Bereich (100) des Spaltes mithilfe der optischen Welle beleuchtet wird, **dadurch gekennzeichnet, dass** die Geometrie der leitfähigen Spuren (32, 33) so definiert ist, dass die Eingangsimpedanz und die Ausgangsimpedanz der Schaltvorrichtung, welche durch die Beleuchtung des Bereichs (100) erzeugt werden, an die Impedanz der Übertragungsleitung angepasst sind, wobei die Eingangsimpedanz und die Ausgangsimpedanz bei fehlender Beleuchtung des Bereichs (100) nicht auf die Übertragungsleitung angepasst sind.

2. Vorrichtung nach Anspruch 1, **dadurch gekennzeichnet, dass** im AUS-Zustand die Eingangsimpedanz und die Ausgangsimpedanz 1 Kiloohm überschreiten.

3. Vorrichtung nach einem der vorhergehenden Ansprüche, **dadurch gekennzeichnet, dass** die Breite linear abnimmt.

4. Vorrichtung nach einem der vorhergehenden Ansprüche, **dadurch gekennzeichnet, dass** die Spuren einen Endabschnitt auf Höhe des Spaltes aufweisen, dessen Abmessung einer Länge des Spaltes gleichwertig ist.

5. Vorrichtung nach einem der vorhergehenden Ansprüche, **dadurch gekennzeichnet, dass**, da ihre Struktur eine komplanare Struktur ist, sie eine Grundplatte (28, 48) beiderseits der leitfähigen Spuren (32,33) aufweist, wobei der Abstand zwischen den Grundplatten und den Spuren im Wesentlichen konstant zwischen den Eingangs- und Ausgangsanschlüssen und dem Spalt bleibt.

6. Vorrichtung nach einem der vorhergehenden Ansprüche, **dadurch gekennzeichnet, dass** die Länge des Spaltes unter 1 µm beträgt.

7. Vorrichtung nach Anspruch 5, **dadurch gekennzeichnet, dass** die Länge des Spaltes in der Größenordnung von 0,5 µm liegt.

8. Elektronisches Bauteil, **dadurch gekennzeichnet, dass** es eine Vorrichtung nach einem der vorhergehenden Ansprüche enthält.

9. Elektronisches Bauteil nach Anspruch 8, **dadurch gekennzeichnet, dass** es die Funktion einer Abtast-Halteschaltung (6) versieht.

## Claims

1. A device for switching an electrical signal, controlled by an optical wave (35) and having an on state and an off state, which can be inserted into a microwave transmission line, said device comprising a semiconductor substrate (20, 21) on which two conductive tracks (32, 33) are formed, these tracks being separated by a gap (34) providing electrical insulation between the two tracks and each being connected to an input port and an output port (36, 37), said conductive tracks (32,33) ending at said gap (34), the width of the conductive tracks (32, 33) decreasing from the input and output ports (36, 37) to said gap (34), in the on state the electrical contact between the two tracks being established by illuminating the substrate in the region (100) of the gap by means of the optical wave, **characterized in that** the geometry of said conductive tracks (32, 33) is defined so that the input impedance and the output impedance of said switching device created by the illumination of said zone (100) are matched to the impedance of said transmission line, said input impedance and said output impedance are mismatched to said transmission line in the absence of illumination of said zone (100).

2. The device as claimed in claim 1, **characterized in that** in the off state, the input impedance and the output impedance are more than one kiloohm.

3. The device as claimed in any one of the claim preceding claims, **characterized in that** the width decreases linearly.

4. The device as claimed in any one of the preceding claims, **characterized in that** the tracks have a termination at the gap with a dimension equivalent to the width of the gap.

5. The device as claimed in any one of the preceding claims , **characterized in that**, its structure being of the coplanar type, it has a ground plane (28, 48) on each side of the conductive tracks (32,33), the distance between the ground planes and the tracks remaining substantially constant between the input and output ports and the gap.

6. The device as claimed in any one of the preceding claims, **characterized in that** the length of the gap is less than 1 µm.

7. The device as claimed in claim 5, **characterized in that** the length of the gap is of the order of 0,5 µm.

8. An electronic component, **characterized in that** it incorporates a device as claimed in any one of the preceding claims.

9. The electronic component as claimed in claim 8, **characterized in that** it fulfills the function of a sample-and-hold circuit (6).
